# EUROPEAN PATENT APPLICATION

(11) **EP 4 345 881 A1**
(43) Date of publication of application: **03.04.2024**
(21) Application number: 23194055.2
(22) Date of filing: 29.08.2023
(51) Int. Cl.: H01L 21/8238, H01L 27/092, H01L 29/78, H01L 27/02, H01L 29/775

(54) **ULTRA-LOW THRESHOLD VOLTAGE TRANSISTOR CELL LAYOUT**

(30) Priority: 29.09.2022 US 202217956188
(71) Applicant: Intel Corporation, Santa Clara, CA 95054 (US)
(72) Inventor: CHU, Tao, Portland 97229 (US); JANG, Minwoo, Portland 97229 (US); LUO, Yanbin, Portland 97229 (US); PACKAN, Paul, Hillsboro 97124 (US)
(74) Representative: HGF

(57) **Abstract**

Integrated circuit dies, apparatuses, systems, and techniques, are described herein related to low and ultra-low threshold voltage transistor cells. A first transistor cell (191) includes separate semiconductor bodies contacted by separate gate electrodes having a dielectric material therebetween. A second transistor cell (192) includes separate semiconductor bodies contacted by a shared gate electrode that couples to both semiconductor bodies. Transistors of the second transistor cell may be operated at a lower threshold voltage than those of the first transistor cell due to increased strain on the semiconductor bodies from the shared gate electrode.

## Description

### BACKGROUND

There is an ongoing need for improved computational devices to enable ever increasing demand for modeling complex systems, providing reduced computation times, and other considerations. In some contexts, scaling features of integrated circuits has been a driving force for such improvements. Other advancements have been made in materials, device structure, circuit layout, and so on. Currently, there is a need for ultra-low PMOS (p-type metal-oxide-semiconductor) threshold voltage devices. Achieving ultra-low PMOS threshold voltage (ULVTP) faces numerous challenges. Current approaches include work function metal tuning, dopant implant, and forming a PMOS dipole in the device. However, these approaches face difficulties such as work function metal tuning causing difficulties in filling narrow gate trenches, dopant implant techniques causing degradation in mobility, dipole formation causing processing complications, and others.

It is with respect to these and other considerations that the present improvements have been needed. Such improvements may become critical as the desire to improve computational efficiency become even more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 illustrates a top-down view of an integrated circuit system having low voltage transistor cells and ultra-low voltage transistor cells over a common substrate;
FIG. 2 illustrates an isometric view an example Fin FET for deployment in the integrated circuit system of FIG. 1;
FIG. 3 illustrates an isometric view an example gate all around (GAA) FET for deployment in the integrated circuit system of FIG. 1;
FIG. 4 illustrates an isometric view an example multi-Fin FET for deployment in the integrated circuit system of FIG. 1;
FIG. 5 illustrates a cross-sectional view of the integrated circuit system of FIG. 1 at a gate cut between gate electrodes;
FIG. 6 illustrates a cross-sectional view of the integrated circuit system of FIG. 1 at a shared gate electrode;
FIG. 7 illustrates a top-down view of an ultra-low voltage transistor cell having additional shared gate electrode transistors;
FIG. 8 illustrates a top-down view of an ultra-low voltage transistor cell having shared gate electrode transistors and a gate cut pair of transistors;
FIG. 9 is a flow diagram illustrating an example process for forming an integrated circuit die or system having low voltage transistor cells and ultra-low voltage transistor cells over a common substrate;
FIG. 10 illustrates exemplary systems employing low and ultra-low threshold voltage transistor cells in a same integrated circuit die; and
FIG. 11 is a functional block diagram of an electronic computing device, all in accordance with some embodiments.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of' or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Integrated circuit dies, apparatuses, systems, and techniques are described herein related to selectively utilizing gate cut layout for ultra-low voltage transistor cell design.

As discussed, there is a need for ultra-low PMOS (p-type metal-oxide-semiconductor) threshold voltage devices in various computing contexts. However, the ultra-low PMOS threshold voltage option has been a challenge for advanced nodes in the semiconductor industry. In some embodiments, an apparatus, integrated circuit (IC) die, or system includes multiple transistor cells. As used herein, the term transistor cell indicates a number of transistors in a shared region of a device that are interconnected and optionally used to provide a function or functions. In some embodiments, each transistor cell is a CMOS (complementary metal-oxide-semiconductor) cell having PMOS transistors and NMOS (n-type metal-oxide-semiconductor) transistors. In some embodiments, a first of the transistor cells includes a first transistor including a first gate electrode coupled to a first semiconductor body, a second transistor including a second gate electrode coupled to a second semiconductor body, such that the first and second gate electrode are separated and electrically isolated by dielectric material. A second of the transistor cells includes a first transistor coupled to a first semiconductor body and a second transistor including a second gate electrode coupled to a second semiconductor body, such that the first and second transistors share a contiguous gate electrode. The term shared indicates the gate is coupled to both semiconductor bodies and the contiguous is used in its ordinary meaning to indicate the shared electrode may include one or more material that touch one another. In some embodiments, the shared electrode includes one or more materials that are continuous, such as a fill metal.

By proving gate cuts in the first transistor cell (i.e., the first and second gate electrodes are cut and separated from one another) and no gate cuts in the second transistor cell (i.e., the gate electrode is shared across the semiconductor bodies, different strains are applied to the channel regions in the first and second transistor cells. Such strains, in turn, impact the threshold voltages and mobilities of the respective transistors. For example, the NMOS transistors in the second transistor cell (i.e., without gate cut) may have a threshold voltage of about 0 to 10 mV higher than the NMOS transistors in the first transistor cells and a mobility of about 10% less. The PMOS transistors in the second transistor cell (i.e., without gate cut) may have a threshold voltage of about 60 mV lower than the PMOS transistors in the first transistor cells and a mobility of about 10% greater. In particular, the effect on the PMOS transistors is advantageously leveraged to provide ultra-low PMOS in the second transistor cell. It is noted that ultra-low NMOS transistors in the second transistor cell may be effectuated using known techniques that are outside of the scope of the present application inclusive of work function metal tuning, implantation, and others.

Thereby, the first transistor cells may operate at low threshold voltage and the second transistor cells may operate at ultra-low threshold voltage. Such terms are relative and may include operation at any suitable threshold voltages such that the transistor cells without gate cuts operate at a lower threshold voltage than the transistor cells with gate cuts. In some embodiments, the transistor cells with gate cuts operate at a threshold voltage of not more than 250 mV or not more than 200 mV, and the transistor cells without gate cuts operate at a threshold voltage of 60 mV less than or a voltage of 40 mV less than the transistor cells with gate cuts. Other operating threshold voltages may be used.

Such techniques provide for ultra-low threshold voltage, particularly for PMOS transistors, using gate cut plugs (e.g., not using gate cuts) to impose a stress on the channel regions of the PMOS transistors, which creates the desired ultra-low threshold voltage delta (i.e., about-60 mV). By incorporating such structures and design into a transistor cell or unit cell, lower PMOS Vt (threshold voltage) is achieved, and greater circuit design flexibility is provided in the IC device. For example, when incorporated in silicon based semiconductor bodies, VTN (NMOS threshold) is about 0-10 mV higher, VTP (PMOS threshold) is about 60 mV lower, NMOS mobility is about 10% lower, and PMOS mobility is about 10% higher in non-gate cut cells relative to gate cut cells, which are illustrated herein below.

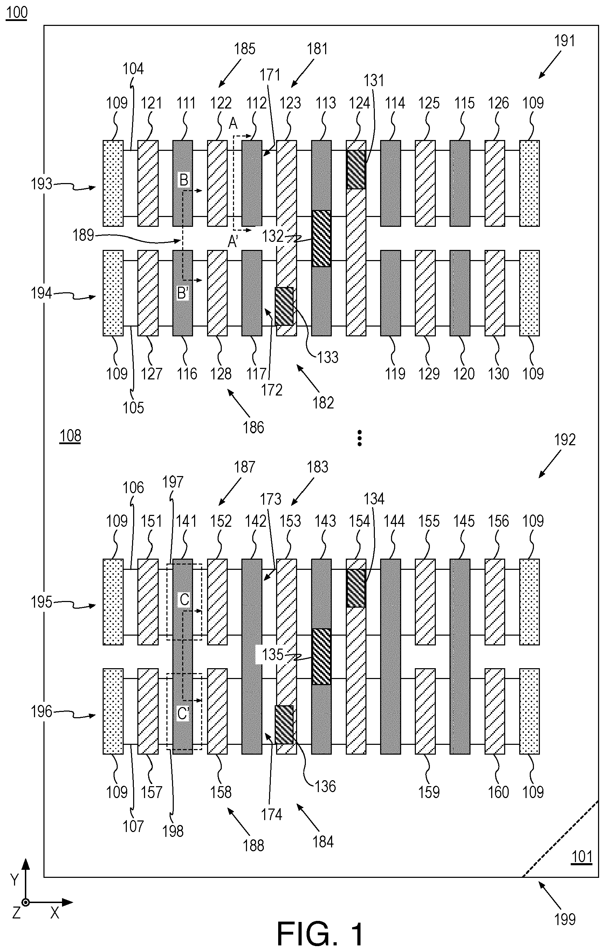

FIG. 1 illustrates a top-down view of an integrated circuit system 100 having low voltage transistor cells 191 and ultra-low voltage transistor cells 192 over a common substrate 101, arranged in accordance with at least some implementations of the present disclosure. Low voltage transistor cells 191 and ultra-low voltage transistor cells 192 may be arrayed or arranged over substrate 101 in any suitable layout. Furthermore, low voltage transistor cells 191 and ultra-low voltage transistor cells 192 may each include additional transistors or device structures. As shown, structures of low voltage transistor cells 191 and ultra-low voltage transistor cells 192 are embedded in a dielectric material 108. Dielectric material 108 may be any suitable dielectric material such as silicon nitride, silicon oxynitride, or the like. Although dielectric material 108 may be over some structures of low voltage transistor cells 191 and ultra-low voltage transistor cells 192, such structures are revealed for the sake of clarity of presentation.

As shown in cutaway 199, the discussed structures are over common substrate 101. Substrate 101 may include any suitable material or materials. For example, substrate 101 may be a substrate substantially aligned along a predetermined crystal orientation (e.g., (100), (111), (110), or the like). In some examples, substrate 101 may include a semiconductor material such as monocrystalline silicon (Si), germanium (Ge), silicon germanium (SiGe), a III-V materials based material (e.g., gallium arsenide (GaAs)), a silicon carbide (SiC), a sapphire (Al₂O₃), or any combination thereof. In some examples, substrate 101 may include silicon having a (100) crystal orientation with a 4°-11 ° miscut (with 4°-6° being particularly advantageous). Examples using silicon having a crystal orientation of (110) or (111) may offer the advantage of having a smaller mismatch for subsequent epitaxial growth. For example, substrate 101 may be (111) silicon, (100) silicon, or (110) silicon. In an embodiment, substrate 101 includes a (111) crystalline group IV material.

Low voltage transistor cell 191 is on or over substrate 101. Low voltage transistor cell 191 includes a semiconductor body 104 to support NMOS transistors 193 and a semiconductor body 105 to support PMOS transistors 194. In a similar manner, ultra-low voltage transistor cell 192 is on or over substrate 101, and ultra-low voltage transistor cell 192 includes a semiconductor body 106 to support NMOS transistors 195 and a semiconductor body 107 to support PMOS transistors 196. Herein, an NMOS transistor is a transistor with n-type source and drain materials. For example, the source and drain may be an intrinsic semiconductor material doped with an n-type dopant such as phosphorous, arsenic, or antimony. Such NMOS transistors may be inversion type such that the channel semiconductor is p-type and, during operation, an inversion layer is formed in the channel to allow conduction of electrons through the channel. A PMOS transistor is a transistor with p-type source and drain materials. For example, the source and drain may be an intrinsic semiconductor material optionally doped with a p-type dopant such as boron or gallium. Such PMOS transistors may again be inversion type such that the channel semiconductor is n-type and, during operation, an inversion layer is formed in the channel to allow conduction of holes through the channel.

Semiconductor bodies 104, 106 may have the same characteristics such as the same channel materials and semiconductor bodies 105, 107 may have the same characteristics such as the same channel materials. In some embodiments, a transistor 181 includes a channel region 171 coupled to a gate electrode 112, a source or drain structure 122 and a source or drain structure 123. A transistor 185 includes a channel region (not labeled) coupled to a gate electrode 111, a source or drain structure 121 and source or drain structure 122. For example, transistors 181, 185 may share source or drain structure 122. Furthermore, a transistor 182 includes a channel region 172 coupled to a gate electrode 117, a source or drain structure 128 and source or drain structure 123 such that transistors 181, 182 share source or drain structure 113. A transistor 186 includes a channel region (not labeled) coupled to a gate electrode 116, a source or drain structure 127 and source or drain structure 128 such that transistors 182, 186 may share source or drain structure 128. Similarly, gate electrodes 114, 115, 119, 120 and sources or drains 124, 125, 126, 129, 130 may be used to form transistors of low voltage transistor cell 191. Isolation structures 109, such as silicon dioxide dielectric material may be used to isolate semiconductor bodies 105-106.

Notably, each of corresponding ones of gate electrodes 111, 116, gate electrodes 112, 117, gate electrodes 114, 119, gate electrodes 115, 120, and so on are gate cut 189 such that they are isolated and separated from one another (i.e., they do not touch) by dielectric material 108. In contrast to ultra-low voltage transistor cells 192, such gate cuts provide lower strain on channel regions 171, 172, and so on. Gate electrodes 111-120 may be on a gate dielectric layer (discussed herein below) and may include of at least one of a p-type work function metal or an n-type work function metal, depending on whether the transistor is a PMOS or an NMOS transistor. In some embodiments, each of gate electrodes 111-120 is a stack of two or more metal layers, where one or more metal layers are work function metal layers and at least one metal layer is a fill metal layer. For PMOS transistors 194, metals that may be used for gate electrodes 111-120 include, but are not limited to, ruthenium, palladium, platinum, cobalt, nickel, and conductive metal oxides, e.g., ruthenium oxide. A p-type metal layer will enable the formation of a PMOS gate electrode with a work function that is between about 4.9 eV and about 5.2 eV. For NMOS transistors 193, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An n-type metal layer will enable the formation of an NMOS gate electrode with a work function that is between about 3.9 eV and about 4.2 eV.

As shown, such gate electrodes and source or drain materials may be contacted by gate contacts such as exemplary gate contact 132, and source or drain contacts such as exemplary drain contact 133 and exemplary source contact 131. As discussed, sources or drains 121-130 may be any suitable material such as doped semiconductor materials. Contacts 131-133 may land on and electrically coupled to sources or drains 121-130 and gate electrodes 111-120 to provide any suitable circuitry of low voltage transistor cell 191. Such contacts may include a contact metal for example such as tungsten or the like and may be interconnected by overlying metallization layers.

Corresponding features of ultra-low voltage transistor cell 192 advantageously employ the same materials and structures as low voltage transistor cell 191. For example, low voltage transistor cell 191 and ultra-low voltage transistor cell 192 are fabricated using the same operations applied over substrate 101. The layout differences between low voltage transistor cell 191 and ultra-low voltage transistor cell 192 and, in particular, the removal gate cuts 189 provides for increased strain on channel regions 174 of PMOS transistors 196 for lower threshold voltage operation of PMOS transistors 196 ultra-low voltage transistor cell 192.

As shown, ultra-low voltage transistor cell 192 is also on or over substrate 101. As discussed, ultra-low voltage transistor cell 192 includes semiconductor body 106 to support NMOS transistors 195 and semiconductor body 107 to support PMOS transistors 196. A transistor 183 includes a channel region 173 coupled to a first region of a shared gate electrode 142, a source or drain structure 152 and a source or drain structure 153. A transistor 187 includes a channel region (not labeled) coupled to a first region 197 of a shared gate electrode 141, a source or drain structure 151 and source or drain structure 152. As shown, transistors 183, 187 may share source or drain structure 152. Furthermore, a transistor 184 includes a channel region 174 coupled to a second region 198 of shared gate electrode 142, a source or drain structure 158 and source or drain structure 153 such that transistors 181, 182 share source or drain structure 153. A transistor 188 includes a channel region (not labeled) coupled to a second region of shared gate electrode 141, a source or drain structure 157 and source or drain structure 158 such that transistors 184, 188 may share source or drain structure 158. Similarly, shared gate electrodes 144, 145 and sources or drains 154, 155, 156, 159, 160 may be used to form transistors of ultra-low voltage transistor cell 192.

Notably, each of shared gate electrodes 141, 142, 143, 144, 145, and so on have no gate cut such that they are contiguous gate structures, and provide increased strain on channel regions 174 of PMOS transistors 196 relative to channel regions 171, 172 of PMOS transistors 194 of low voltage transistor cell 191. Regions 197, 198 of shared gate electrodes 141-145 may be on a gate dielectric layer (discussed herein below) and may include of at least one of a p-type work function metal or an n-type work function metal, depending on whether the transistor is a PMOS or an NMOS transistor as discussed above. In some embodiments, region 197 includes a stack of an n-type work function metal and a fill metal and region 198 includes a stack of a p-type work function metal and the fill metal. In some embodiments, shared gate electrodes 141, 142, 143, 144, 145 are continuous and regions 197, 198 have the same composition.

As shown, such gate electrodes and source or drain materials may be contacted by gate contacts such as exemplary gate contact 135, and source or drain contacts such as exemplary drain contact 136 and exemplary source contact 134. Sources or drains 151-160 may be any suitable material such as doped semiconductor materials discussed herein. Contacts 134-136 land on and electrically coupled to sources or drains 151-160 and gate electrodes 141-145 and are interconnected by overlying metallization layers.

As shown, IC system 100 (e.g., an apparatus, IC die, packaged IC die, etc.) includes having low voltage transistor cell(s) 191 and ultra-low voltage transistor cells() 192 over substrate 101. Low voltage transistor cell 191 includes transistor 181, which includes gate electrode 112 coupled to semiconductor body 104, and transistor 182, which includes gate electrode 117 coupled semiconductor body 105 such that semiconductor bodies 104, 105 are substantially parallel. Low voltage transistor cell 191 also includes dielectric material 108 separating gate electrode 112 from gate electrode 117, and transistors 181, 182 include a shared source or drain structure 123 coupled to both semiconductor bodies 104, 105. Ultra-low voltage transistor cell 192 includes transistor 183, which includes semiconductor body 106, and transistor 184, which includes semiconductor body 107 such that semiconductor bodies 106, 107 are substantially parallel. Transistors 183, 184 include shared source or drain structure 153 coupled to both semiconductor bodies 106, 107 and shared gate electrode 142 (i.e., a contiguous gate electrode) coupled to both semiconductor bodies 106, 107. As discussed, in some embodiments, transistors 181, 183 are NMOS transistors and transistors 182, 184 are PMOS transistors. Also as discussed, transistor 184 is to operate at a lower threshold voltage than transistor 182.

In some embodiments, each of NMOS transistors 193 has a gate electrode that is separated from a corresponding gate electrode of each of PMOS transistors 194 by dielectric material 108, and each of NMOS transistors 195 and corresponding ones of PMOS transistors 196 have a shared gate electrode extending orthogonal to semiconductor bodies 106, 107. As discussed, corresponding components of low voltage transistor cells 191 and ultra-low voltage transistor cells 192 may have the same characteristics inclusive of materials. In some embodiments, channel region 171 and channel region 173 have a same first material composition, and channel region 173 and channel region 174 have a same second material composition different than the first material composition.

Semiconductor bodies 104-107 may have any suitable cross-sectional shape or architecture. For example, transistors 193-196 may be planar transistors, Fin FETs (field effect transistors), gate all around (GAA) FETs, etc. A planar transistor indicates a transistor having a single plane interface between the gate and channel structure thereof. As used herein the term non-planar transistor indicates a transistor having more than a single plane interface between the gate and channel structure. Such non-planar transistors may also be characterized as multi-gate devices, multi-gate MOSFETs, or the like. In some embodiments, the non-planar transistors are Fin FET devices where the gate is on two, three, or four sides of a fin of channel material. In some embodiments, the non-planar transistors are gate all around (GAA) FET devices where the gate surrounds one or more channel regions on all sides. Such channel regions may be nanowires or nanoribbons of channel material for example. In some embodiments, the non-planar transistors are nanosheet FET devices where the gate again surrounds one or more channel regions on all sides but, in contrast to GAA FET devices, the channel regions are nanosheets having a substantially greater width than height (i.e., a width to height ratio in the range of 2 to 10). In some embodiments, the non-planar transistors are floating Fin FET devices, which are similar to Fin FET devices with the sub-fin of the fin material removed such that a void is under the floating fin.

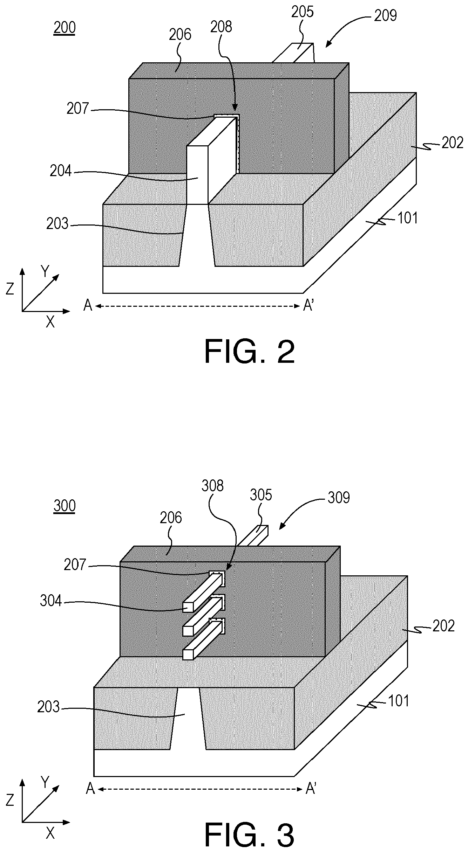

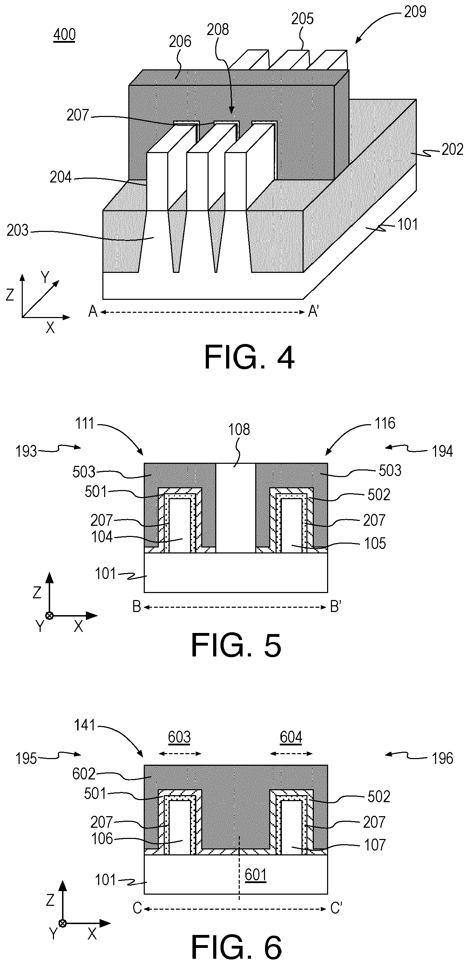

FIG. 2 illustrates an isometric view an example Fin FET 200 for deployment in integrated circuit system 100, arranged in accordance with at least some implementations of the present disclosure. With reference to FIG. 1, the isometric view of FIG. 2 is taken at plane A-A', and Fin FET 200 is representative of any transistor in low voltage transistor cells 191 or ultra-low voltage transistor cells 192. As shown, Fin FET 200 may be formed on or over substrate 101 and a fin 209 may be deployed as any of semiconductor bodies 104-107. In the example of FIG. 2, a single fin is used; however multiple fins may be used as shown in FIG. 4, stacked nano-ribbons may be used as shown in FIG. 3, or multiple stacks of stacked nano-ribbons may be used, which is a combination of the examples of FIGS. 3 and 4.

In some embodiments, a sub-fin 203 (i.e., embedded in dielectric material 202) and fin 209 are formed of substantially the same material as substrate101 using patterning and etch techniques. In some embodiments, fin 209 and sub-fin 203 may be formed using growth techniques such as epitaxial growth techniques, and fin 209 and sub-fin 203 may be the same or different material with respect to substrate101. For example, fin 209 and sub-fin 203 may include any material or material discussed with respect to substrate101, although they need not be the same material.

Fin FET 200 further includes a gate electrode structure 206 (i.e., any of gate structures 111-120 or regions of gate structures 141-145) on a gate dielectric 207. Gate electrode structure 206 may include one layer or a stack of layers, as discussed further herein. The one or more layers of gate dielectric 207 may include silicon oxide, silicon dioxide (SiO₂), and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in gate dielectric 207 include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

Fin 209 of Fin FET 200 provides a channel region 208 (i.e., channel regions 171-174, which are obscured in FIG. 1) that extends between a source 204 and a drain 205 of fin 209. Source 204 and drain 205 may be coupled to source or drain structures 121-130, 151-160. In some embodiments, source or drain structures 121-130, 151-160 are semiconductor materials doped with the pertinent conductivity type dopants. For example, n-type dopants include phosphorous, arsenic, and antimony and p-type dopants include boron and gallium. In some embodiments, source or drain structures 121-130, 151-160 may be epitaxially grown from source 204 and drain 205.

FIG. 3 illustrates an isometric view an example gate all around (GAA) FET 300 for deployment in integrated circuit system 100, arranged in accordance with at least some implementations of the present disclosure. With reference to FIG. 1, the isometric view of FIG. 3 is taken at plane A-A', and Fin FET 200 is representative of any transistor in low voltage transistor cells 191 or ultra-low voltage transistor cells 192. GAA FET 300 is formed on or over substrate 101 and nanoribbons or nanowires 309 may be formed, as is known in the art. For example, nanowires 309 may be formed of the substantially the same material as substrate101 using any suitable technique or techniques such as patterning and etch techniques or nanowires 309 may be formed from a multilayer stack of etch selective materials.

GAA FET 300 includes gate structure 206 (i.e., gate structures 111-120 or regions of gate structures 141-145) on gate dielectric 207. Notably, gate dielectric 207 and gate electrode 206 surround channel regions 308 of each of nanowires 309. Nanowires 309 of GAA FET 300 provide channel regions 308 (i.e., channel regions 171-174) that extend between source 304 and drain 305. Source 304 and drain 305 may be coupled to source or drain structures 121-130, 151-160. In some embodiments, source or drain structures 121-130, 151-160 are semiconductor materials doped with the pertinent conductivity type dopants. For example, n-type dopants include phosphorous, arsenic, and antimony and p-type dopants include boron and gallium. In other embodiments, source or drain structures 121-130, 151-160 may be epitaxially grown from source 304 and drain 305.

FIG. 4 illustrates an isometric view an example multi-Fin FET 400 for deployment in integrated circuit system 100, arranged in accordance with at least some implementations of the present disclosure. With reference to FIG. 1, the isometric view of FIG. 4 is taken at plane A-A', and Fin FET 200 is representative of any transistor in low voltage transistor cells 191 or ultra-low voltage transistor cells 192. As shown, multi-Fin FET 400 may be formed on or over a substrate 101 and any number of fins 209 may be deployed as any of semiconductor bodies 104-107. In the example of FIG. 4, three fins are deployed. However, two, four, or more fins may be used.

Multi-Fin FET 400 includes gate electrode structure 206 (i.e., gate structures 111-120 or regions of gate structures 141-145) on gate dielectric 207, which is on each of fins 209. Fins 209 of multi-Fin FET 400 provide channel regions 208 (i.e., channel regions 171-174) that extends between sources 204 and drains 205 of multi-Fin FET 400. Sources 204 and drains 205 may be coupled to source or drain structures 121-130, 151-160, as discussed with respect to FIG. 2 and elsewhere herein.

With reference to FIG. 1, corresponding ones of gate electrodes 111, 116, gate electrodes 112, 117, gate electrodes 114, 119, gate electrodes 115, 120, and so on are gate cut 189 such that they are isolated and separated from one another (i.e., they do not touch) by dielectric material 108, while shared gate electrodes 141-145 are not gate cut to provide strain on channel regions 174 of PMOS transistors 196.

FIG. 5 illustrates a cross-sectional view of integrated circuit system 100 at gate cut 189 between gate electrodes 111, 116, arranged in accordance with at least some implementations of the present disclosure. With reference to FIG. 1, the cross-sectional view of FIG. 5 is taken at plane B-B'. As shown in FIG. 5, dielectric material 108 separates and electrically isolates gate electrode 111 and gate electrode 116. For example, dielectric material 108 extends vertically from substrate 101 and is laterally between gate electrode 111 and gate electrode 116 to provide electrical isolation and strain relief. Also as shown, gate dielectric 207 is on semiconductor bodies 104, 105 (illustrated as FinFETs in FIG. 5). Gate electrode 111 is on gate dielectric 207 over semiconductor body 104 and gate electrode 116 is on gate dielectric 207 over semiconductor body 105.

As discussed, gate electrodes 111, 116 may include work function metals and fill metals. In some embodiments, gate electrode 111, a component of NMOS transistor 193, includes n-type work function metal 501 and fill metal 503, and gate electrode 116, a component of PMOS transistor 194, includes p-type work function metal 502 and fill metal 503. For example, gate electrodes 111, 116 may include the same fill metal 503 and different work function metals. P-type work function metal 502 may include any suitable p-type work function metal such as ruthenium, palladium, platinum, cobalt, nickel, and conductive metal oxides, e.g., ruthenium oxide. In the same manner, n-type work function metal 501 may include any suitable n-type work function metal such as hafnium, zirconium, titanium, tantalum, aluminum, alloys of these metals, and carbides of these metals such as hafnium carbide, zirconium carbide, titanium carbide, tantalum carbide, and aluminum carbide. As shown, in some embodiments, dielectric material 108 laterally separates n-type work function metal 501 from p-type work function metal 502 and laterally separates portions of fill metals 503.

FIG. 6 illustrates a cross-sectional view of integrated circuit system 100 at shared gate electrode 141, arranged in accordance with at least some implementations of the present disclosure. With reference to FIG. 1, the cross-sectional view of FIG. 6 is taken at plane C-C'. As shown in FIG. 6, in some embodiments, shared gate electrode 141 includes a continuous fill metal 602 and a contiguous work function metal layer including n-type work function metal 501 and p-type work function metal 502, which may meet at a seam 601. N-type work function metal 501 and p-type work function metal 502 may be any suitable materials discussed with respect to FIG. 5 and elsewhere herein. Notably, dielectric material 108 does not separate one or both of continuous fill metal 602 and n-type work function metal 501 from p-type work function metal 502 to provide increased strain on the channel region of PMOS transistor 196 and, optionally, on the channel region of NMOS transistor 195.

As shown in FIG. 6, contiguous gate electrode 144 includes a first region 603 over semiconductor body 106 and a second region 604 over semiconductor body 107. First region 603 includes n-type work function metal 501 adjacent semiconductor body 106 (e.g., separated from a channel of semiconductor body 106 by gate dielectric 207) and second region 604 includes p-type work function metal 502 adjacent semiconductor body 107 (e.g., separated from a channel of semiconductor body 107 by gate dielectric 207 or a different gate dielectric material). Such embodiments offer the advantages of work function metals tuned to the pertinent transistor type and strain on the channel of PMOS transistor 196 and, optionally, on the channel region of NMOS transistor 195.

Ultra-low voltage transistor cells 192 may include any number of corresponding pair transistors having shared gate electrodes. In some embodiments, each pair of transistors (e.g., one NMOS transistor and one PMOS transistor in each pair) in ultra-low voltage transistor cell 192 has a shared gate electrode. In some embodiments, one or more paired transistors have a gate cut. Notably, by increasing the number of shared gate electrodes, the threshold voltage of the PMOS transistors in ultra-low voltage transistor cell 192 can be reduced. In some embodiments, the reduction is substantially continuous such that, for example, going from two shared gate electrodes to three shared electrodes reduces the threshold voltage of the PMOS transistors by about the same amount as going from three shared gate electrodes to four shared electrodes, and so on.

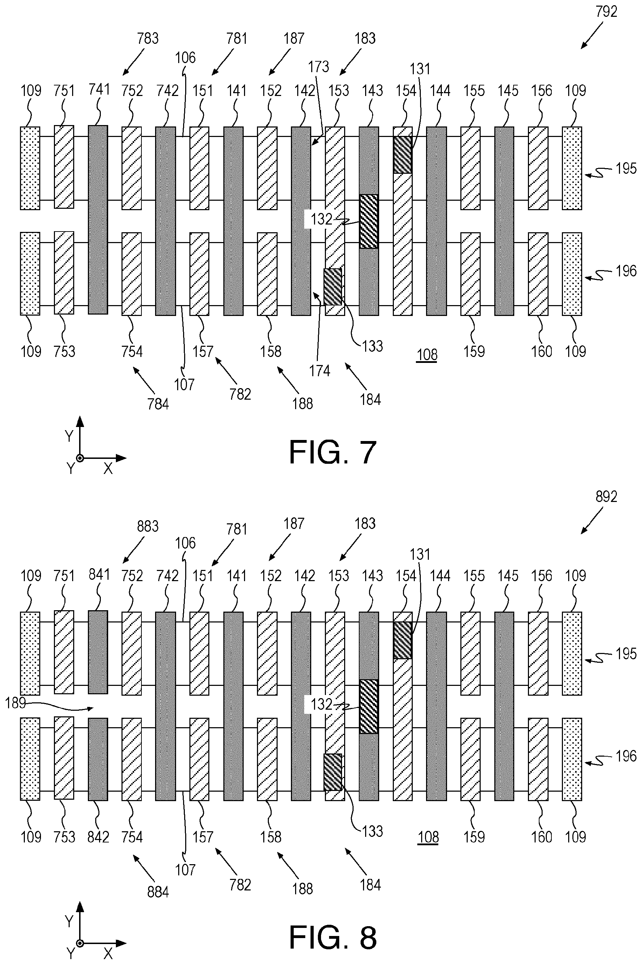

FIG. 7 illustrates a top-down view of an ultra-low voltage transistor cell 792 having additional shared gate electrode transistors, arranged in accordance with at least some implementations of the present disclosure. For example, ultra-low voltage transistor cell 792 may be similar to ultra-low voltage transistor cell 192 with the exception that ultra-low voltage transistor cell 792 has additional transistors 781-784. Although illustrated with two additional paired transistors (e.g., one NMOS transistor and one PMOS transistor in each pair), any number of additional paired transistors may be added to ultra-low voltage transistor cell 792. Although not illustrated for the sake of clarity, a system such as IC system 100 may include a corresponding low voltage transistor cell similar to low voltage transistor cell 191 but with additional transistors having gate cut 189.

As discussed, transistor 183 includes channel region 173 coupled to a first region of shared gate electrode 142, source or drain structure 152 and source or drain structure 153. Transistor 187 includes a channel region (not labeled) coupled to a first region (not labeled in FIG. 7) of shared gate electrode 141, source or drain structure 151 and source or drain structure 152, such that transistors 183, 187 may share source or drain structure 152. Transistor 184 includes channel region 174 coupled to a second region (not labeled in FIG. 7) of shared gate electrode 142, a source or drain structure 128 and source or drain structure 123 such that transistors 181, 182 share source or drain structure 153. Transistor 188 includes a channel region (not labeled) coupled to a second region of shared gate electrode 141, source or drain structure 157 and source or drain structure 158 such that transistors 184, 188 may share source or drain structure 158. In ultra-low voltage transistor cell 792, additional transistors are provided as follows.

A transistor 781 (i.e., an NMOS transistor 195) includes a channel region coupled to a first region of shared gate electrode 742, a source or drain structure 752 and source or drain structure 151 such that transistors 781, 187 may share source or drain structure 151. A paired transistor 782 (i.e., a PMOS transistor 196) includes a channel region coupled to a second region of shared gate electrode 742, a source or drain structure 754 and source or drain structure 157 such that transistors 782, 188 may share source or drain structure 157. In a similar manner, a transistor 783 (i.e., an NMOS transistor 195) includes a channel region coupled to a first region of shared gate electrode 741, a source or drain structure 751 and source or drain structure 752 such that transistors 783, 781 may share source or drain structure 752, and a paired transistor 784 (i.e., a PMOS transistor 196) includes a channel region coupled to a second region of shared gate electrode 741, a source or drain structure 753 and source or drain structure 754 such that transistors 784, 782 may share source or drain structure 754. In the example of ultra-low voltage transistor cell 792, each transistor pair (e.g., one NMOS transistor and one PMOS transistor coupled to semiconductor body 106 and semiconductor body 107, respectively) are coupled by a shared gate electrode. This provides a maximum amount of strain on the channel regions of PMOS transistors 196 for a lowest threshold voltage operation.

In some embodiments, one or more gate cuts may be provided in the ultra-low voltage transistor cell to marginally increase the operating threshold voltage of PMOS transistors 196. When combined in a common IC system 100, such variation allows for implementation of ultra-low voltage transistor cell having different threshold voltage operation. Such variety has numerous advantages inclusive of circuit design flexibility, operational flexibility, and others.

FIG. 8 illustrates a top-down view of an ultra-low voltage transistor cell 892 having shared gate electrode transistors and a gate cut pair of transistors, arranged in accordance with at least some implementations of the present disclosure. For example, ultra-low voltage transistor cell 892 may be similar to ultra-low voltage transistor cell 792 with the exception that gate electrodes 841, 842 of paired transistors 883, 884 have gate cut 189 therebetween. Although illustrated with a single gate cut pair of transistors (e.g., one NMOS transistor and one PMOS transistor in the pair), two or more gate cuts may be deployed in ultra-low voltage transistor cell 892. However, limiting gate cuts to two or one mitigates the loss of channel strain discussed herein. As discussed with respect to FIG. 7, a system such as IC system 100 may include a corresponding low voltage transistor cell similar to low voltage transistor cell 191 but with additional transistors having gate cut 189.

In ultra-low voltage transistor cell 892, transistors 183, 187, 781, 184, 188, 782 have the same characteristics discussed with respect to ultra-low voltage transistor cell 892. As shown, a transistor 883 (e.g., an NMOS transistor 195) of ultra-low voltage transistor cell 892 includes a gate electrode 841 coupled to a channel region of semiconductor body 106, source or drain structure 751 and source or drain structure 752. For example, transistors 883, 781 may share source or drain structure 752. A transistor 884 (e.g., a PMOS transistor 196 paired with transistor 883) of ultra-low voltage transistor cell 892 includes a gate electrode 842 coupled to a channel region of semiconductor body 107, source or drain structure 753 and source or drain structure 754, such that transistors 884, 782 may share source or drain structure 754. As shown, gate electrode 841 and gate electrode 842 are separated by dielectric material 108 at gate cut 189 (please refer to FIG. 5). Notably, providing a mix of one or more gate cuts with shared gate electrodes in ultra-low voltage transistor cell 892 reduces the amount of strain on the channel regions of PMOS transistors 196 relative to that of ultra-low voltage transistor cell 892, but provides a greater strain than a low voltage transistor cell having all gate cuts.

Thereby, transistor cells of differing threshold voltage operation are provided. It is noted that such differing threshold voltage may caused in PMOS transistors 196 through the strain variation discussed herein. In addition, differing threshold voltage may be attained in NMOS transistors using alternative techniques such as work function material tuning, and others. As discussed, by providing transistor cells of differing threshold voltages, various advantages are achieved including flexibility in circuit design, operational voltage, and others.

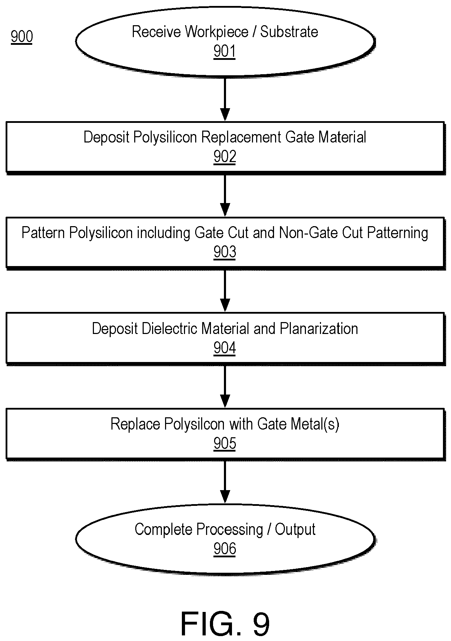

FIG. 9 is a flow diagram illustrating an example process 900 for forming an integrated circuit die or system having low voltage transistor cells and ultra-low voltage transistor cells over a common substrate, arranged in accordance with at least some implementations of the present disclosure. As shown, process 900 begins at operation 901, where a workpiece or substrate is received for processing. The substrate may be any substrate discussed herein such as those discussed with respect to FIG. 1. In some embodiments, the substrate is a wafer. On or over the wafer, structures and components are formed in accordance with techniques known in the art to fabricate any number of semiconductor bodies. For example, semiconductor bodies 104-107 as discussed herein may be formed using techniques known in the art.

Processing continues at operation 902, where a polysilicon layer or film is formed over the semiconductor bodies. The polysilicon layer or film may be formed using any suitable technique or techniques such as polysilicon deposition techniques inclusive of chemical decomposition of silane. Processing continues at operation 903, where the polysilicon layer or film is patterned using any suitable technique or techniques such as lithography techniques to define the gate cut and non-gate cut patterns discussed herein. For example, the patterned polysilicon layer or film may be in substantially the same pattern as the pattern of the gate electrodes discussed herein.

Processing continues at operation 904, a dielectric material is deposited and planarization is performed to expose the patterned polysilicon layer. The dielectric material may include any dielectric material discussed herein such as silicon nitride, silicon oxynitride, or the like. The deposition may be performed using any suitable technique or techniques such as chemical vapor deposition (CVD) including low pressure CVD (LPCVD) or plasma enhanced CVD (PECVD). Following the deposition, a planarization operation may be performed to expose the patterned polysilicon layer. For example, the resultant patterned polysilicon layer and dielectric material may have a common co-planar top surface.

Processing continues at operation 905, where the patterned polysilicon layer is replaced with one or more gate metals in a replacement gate process. For example, gate electrodes may be selectively exposed (e.g., using lithography patterning), and the exposed polysilicon gate may be removed and replaced by the pertinent gate stack. Such processing may be repeated (e.g., selective exposing of polysilicon, removal, and fill) to provide any number of gate materials as discussed herein. Processing continues at operation 906, where processing continues as is known in the art, and the resultant device or system is output for implementation.

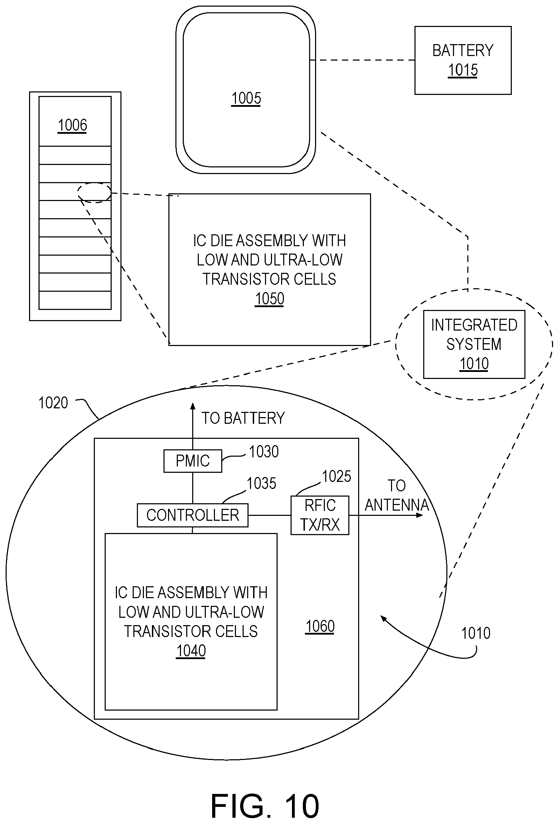

FIG. 10 illustrates exemplary systems employing low and ultra-low threshold voltage transistor cells in a same integrated circuit die, in accordance with some embodiments. The system may be a mobile computing platform 1005 and/or a data server machine 1006, for example. Either may employ a monolithic IC die having low and ultra-low threshold voltage transistor cells as described elsewhere herein. Server machine 1006 may be any commercial server, for example including any number of high-performance computing platforms disposed within a rack and networked together for electronic data processing, which in the exemplary embodiment includes an IC die assembly 1050 with low and ultra-low threshold voltage transistor cells as described elsewhere herein. Mobile computing platform 1005 may be any portable device configured for each of electronic data display, electronic data processing, wireless electronic data transmission, or the like. For example, mobile computing platform 1005 may be any of a tablet, a smart phone, a laptop computer, etc., and may include a display screen (e.g., a capacitive, inductive, resistive, or optical touchscreen), a chip-level or package-level integrated system 1010, and a battery 1015. Although illustrated with respect to mobile computing platform 1005, in other examples, chip-level or package-level integrated system 1010 and a battery 1015 may be implemented in a desktop computing platform, an automotive computing platform, an internet of things platform, or the like. As discussed below, in some examples, the disclosed systems may include a sub-system 1060 such as a system on a chip (SOC) or an integrated system of multiple ICs, which is illustrated with respect to mobile computing platform 1005.

Whether disposed within integrated system 1010 illustrated in expanded view 1020 or as a stand-alone packaged device within data server machine 1006, sub-system 1060 may include memory circuitry and/or processor circuitry 1040 (e.g., RAM, a microprocessor, a multi-core microprocessor, graphics processor, etc.), a power management integrated circuit (PMIC) 1030, a controller 1035, and a radio frequency integrated circuit (RFIC) 1025 (e.g., including a wideband RF transmitter and/or receiver (TX/RX)). As shown, one or more IC dice, such as memory circuitry and/or processor circuitry 1040 may be assembled and implemented such that one or more have a heat removal enhancement as described herein. In some embodiments, RFIC 1025 includes a digital baseband and an analog front end module further comprising a power amplifier on a transmit path and a low noise amplifier on a receive path). Functionally, PMIC 1030 may perform battery power regulation, DC-to-DC conversion, etc., and so has an input coupled to battery 1015, and an output providing a current supply to other functional modules. As further illustrated in FIG. 10, in the exemplary embodiment, RFIC 1025 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1040 may provide memory functionality for sub-system 1060, high level control, data processing and the like for sub-system 1060. In alternative implementations, each of the SOC modules may be integrated onto separate ICs coupled to a package substrate, interposer, or board.

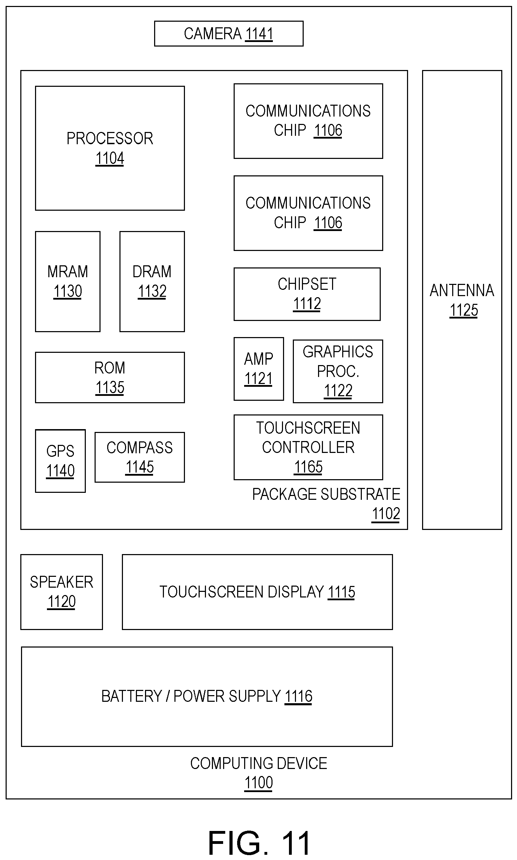

FIG. 11 is a functional block diagram of an electronic computing device 1100, in accordance with some embodiments. For example, device 1100 may, via any suitable component therein, low and ultra-low threshold voltage transistor cells. For example, one or more IC dies of electronic computing device 1100 may deploy low and ultra-low threshold voltage transistor cells on the same IC die and over a common substrate. Device 1100 further includes a motherboard or package substrate 1102 hosting a number of components, such as, but not limited to, a processor 1104 (e.g., an applications processor). Processor 1104 may be physically and/or electrically coupled to package substrate 1102. In some examples, processor 1104 is within an IC assembly. In general, the term "processor" or "microprocessor" may refer to any device or portion of a device that processes electronic data from registers and/or memory to transform that electronic data into other electronic data that may be further stored in registers and/or memory.

In various examples, one or more communication chips 1106 may also be physically and/or electrically coupled to the package substrate 1102. In further implementations, communication chips 1106 may be part of processor 1104. Depending on its applications, computing device 1100 may include other components that may or may not be physically and electrically coupled to package substrate 1102. These other components include, but are not limited to, volatile memory (e.g., DRAM 1132), non-volatile memory (e.g., ROM 1135), flash memory (e.g., NAND or NOR), magnetic memory (MRAM 1130), a graphics processor 1122, a digital signal processor, a crypto processor, a chipset 1112, an antenna 1125, touchscreen display 1115, touchscreen controller 1165, battery/power supply 1116, audio codec, video codec, power amplifier 1121, global positioning system (GPS) device 1140, compass 1145, accelerometer, gyroscope, speaker 1120, camera 1141, and mass storage device (such as hard disk drive, solid-state drive (SSD), compact disk (CD), digital versatile disk (DVD), and so forth, or the like.

Communication chips 1106 may enable wireless communications for the transfer of data to and from the computing device 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1106 may implement any of a number of wireless standards or protocols, including, but not limited to, those described elsewhere herein. As discussed, computing device 1100 may include a plurality of communication chips 1106. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others. Battery/power supply 1116 may include any suitable power supply circuitry and, optionally, a battery source to provide power to components of electronic computing device 1100.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

The following pertain to exemplary embodiments.

In one or more first embodiments, an apparatus comprises a first transistor cell over a substrate, the first transistor cell comprising a first transistor comprising a first gate electrode coupled to a first semiconductor body, a second transistor comprising a second gate electrode coupled to a second semiconductor body substantially parallel to the first semiconductor body, and a dielectric material separating the first gate electrode from the second gate electrode, wherein the first and second transistors comprise a first shared source or drain coupled to the first and second semiconductor bodies, and a second transistor cell over the substrate, the second transistor cell comprising a third transistor comprising a third semiconductor body, and a fourth transistor comprising a fourth semiconductor body substantially parallel to the third semiconductor body, wherein the third and fourth transistors comprise a second shared source or drain coupled to the third and fourth semiconductor bodies, and wherein the third and fourth transistors comprise a contiguous third gate electrode coupled to the third and fourth semiconductor bodies.

In one or more second embodiments, further to the first embodiments, the first and third transistors comprise NMOS transistors and the second and fourth transistors comprise PMOS transistors.

In one or more third embodiments, further to the first or second embodiments, the fourth transistor is to operate at a lower threshold voltage than the second transistor.

In one or more fourth embodiments, further to the first through third embodiments, the first transistor cell comprises a plurality of first NMOS transistors comprising first NMOS gate electrodes and a plurality of first PMOS transistors comprising first PMOS gate electrodes separated from the first NMOS gate electrodes by the dielectric material, and the second transistor cell comprises a plurality of second NMOS transistors and a plurality of second PMOS transistors, wherein corresponding ones of the second NMOS and CMOS transistors comprise shared gate electrodes extending orthogonal to the third semiconductor body.

In one or more fifth embodiments, further to the first through fourth embodiments, the first transistor comprises a first channel region, the second transistor comprises a second channel region, the third transistor comprises a third channel region, and the fourth transistor comprises a fourth channel region, and wherein the first and third channel regions comprise a first material composition and the second and fourth channel regions comprise a second material composition.

In one or more sixth embodiments, further to the first through fifth embodiments, the contiguous third gate electrode comprises a first region over the third semiconductor body and a second region over the fourth semiconductor body, the first region comprising a first work function metal adjacent the third semiconductor body and the second region comprising a second work function metal adjacent the fourth semiconductor body.

In one or more seventh embodiments, further to the first through sixth embodiments, the first and second region each comprises a common continuous fill metal over the first and second work function metals.

In one or more eighth embodiments, further to the first through seventh embodiments, the second transistor cell further comprises a fifth transistor and a sixth transistor, wherein the fifth transistor shares a source or drain with the third transistor and the sixth transistor shares a source or drain with the fourth transistor, and wherein the fifth and sixth transistors comprise a contiguous fourth gate electrode.

In one or more ninth embodiments, further to the first through eighth embodiments, the second transistor cell further comprises a seventh transistor comprising a fifth gate electrode coupled to the third semiconductor body, and an eighth transistor comprising a sixth gate electrode coupled to the fourth semiconductor body, wherein the dielectric material separates the fifth gate electrode from the sixth gate electrode.

In one or more tenth embodiments, further to the first through ninth embodiments, the second transistor cell further comprises a seventh transistor and an eighth transistor, wherein the seventh transistor shares a source or drain with the fifth transistor and the eight transistor shares a source or drain with the sixth transistor, and wherein the seventh and eighth transistors comprise a contiguous fifth gate electrode.

In one or more eleventh embodiments, an apparatus comprises first and second CMOS cells over a substrate, wherein the first CMOS cell comprises a first NMOS transistor comprising a first gate electrode coupled to a first semiconductor body and a first PMOS transistor comprising a second gate electrode coupled to a second semiconductor body, wherein a dielectric material separates the first and second gate electrodes, and the first NMOS and PMOS transistors comprise a first shared source or drain coupled to the first and second semiconductor bodies, and the second CMOS cell comprises a second NMOS transistor comprising a third semiconductor body and a second PMOS transistor comprising a fourth semiconductor body, wherein the second NMOS and PMOS transistors comprise a second shared source or drain coupled to the third and fourth semiconductor bodies, and the second NMOS and PMOS transistors comprise a shared third gate electrode coupled to the third and fourth semiconductor bodies.

In one or more twelfth embodiments, further to the eleventh embodiments, the second PMOS transistor is to operate at a lower threshold voltage than the first PMOS transistor.

In one or more thirteenth embodiments, further to the eleventh or twelfth embodiments, the first PMOS transistor is to operate at a threshold voltage of not more than 250 mV and the second PMOS transistor is to operate at a threshold voltage of not more than 200 mV.

In one or more fourteenth embodiments, further to the eleventh through thirteenth embodiments, the first CMOS cell comprises a plurality of first NMOS transistors comprising first NMOS gate electrodes and a plurality of first PMOS transistors comprising first PMOS gate electrodes separated from the first NMOS gate electrodes by the dielectric material, and the second transistor cell comprises a plurality of second NMOS transistors and a plurality of second PMOS transistors, wherein corresponding ones of the second NMOS and CMOS transistors comprise shared gate electrodes.

In one or more fifteenth embodiments, further to the eleventh through fourteenth embodiments, the shared third gate electrode comprises a first region over the third semiconductor body and a second region over the fourth semiconductor body, the first region comprising a first work function metal adjacent the third semiconductor body and the second region comprising a second work function metal adjacent the fourth semiconductor body, wherein the first and second region each comprises a common continuous fill metal over the first and second work function metals.

In one or more sixteenth embodiments, a system comprises an IC die comprising any of the apparatuses of the first through fifteenth embodiments, and a power supply coupled to the IC die.

In one or more seventeenth embodiments, a system comprises an integrated circuit (IC) die comprising a first transistor cell and a second transistor cell, wherein the first transistor cell comprises a first transistor comprising a first gate electrode coupled to a first semiconductor body, a second transistor comprising a second gate electrode coupled to a second semiconductor body substantially parallel to the first semiconductor body, and a dielectric material separating the first gate electrode from the second gate electrode, wherein the first and second transistors comprise a first shared source or drain coupled to the first and second semiconductor bodies, and wherein the second transistor cell comprises a third transistor comprising a third semiconductor body and a fourth transistor comprising a fourth semiconductor body substantially parallel to the third semiconductor body, wherein the third and fourth transistors comprise a second shared source or drain coupled to the third and fourth semiconductor bodies, and wherein the third and fourth transistors comprise a contiguous third gate electrode coupled to the third and fourth semiconductor bodies, and a power supply coupled to the CMOS die.

In one or more eighteenth embodiments, further to the seventeenth embodiments, the first and third transistors comprise NMOS transistors and the second and fourth transistors comprise PMOS transistors.

In one or more nineteenth embodiments, further to the seventeenth or eighteenth embodiments, the fourth transistor is to operate at a lower threshold voltage than the second transistor.

In one or more twentieth embodiments, further to the seventeenth through nineteenth embodiments, the first transistor cell comprises a plurality of first NMOS transistors comprising first NMOS gate electrodes and a plurality of first PMOS transistors comprising first PMOS gate electrodes separated from the first NMOS gate electrodes by the dielectric material, and the second transistor cell comprises a plurality of second NMOS transistors and a plurality of second PMOS transistors, wherein corresponding ones of the second NMOS and CMOS transistors comprise shared gate electrodes extending orthogonal to the third semiconductor body.

In one or more twenty-first embodiments, further to the seventeenth through twentieth embodiments, the first transistor comprises a first channel region, the second transistor comprises a second channel region, the third transistor comprises a third channel region, and the fourth transistor comprises a fourth channel region, and wherein the first and third channel regions comprise a first material composition and the second and fourth channel regions comprise a second material composition.

In one or more twenty-second embodiments, further to the seventeenth through twenty-first embodiments, the shared third gate electrode comprises a first region over the third semiconductor body and a second region over the fourth semiconductor body, the first region comprising a first work function metal adjacent the third semiconductor body and the second region comprising a second work function metal adjacent the fourth semiconductor body, wherein the first and second region each comprises a common continuous fill metal over the first and second work function metals.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a first transistor cell over a substrate, the first transistor cell comprising:
a first transistor comprising a first gate electrode coupled to a first semiconductor body;
a second transistor comprising a second gate electrode coupled to a second semiconductor body substantially parallel to the first semiconductor body; and
a dielectric material separating the first gate electrode from the second gate electrode, wherein the first and second transistors comprise a first shared source or drain coupled to the first and second semiconductor bodies; and
a second transistor cell over the substrate, the second transistor cell comprising:
a third transistor comprising a third semiconductor body; and
a fourth transistor comprising a fourth semiconductor body substantially parallel to the third semiconductor body, wherein the third and fourth transistors comprise a second shared source or drain coupled to the third and fourth semiconductor bodies, and wherein the third and fourth transistors comprise a contiguous third gate electrode coupled to the third and fourth semiconductor bodies.

2. The apparatus of claim 1, wherein the first and third transistors comprise NMOS transistors and the second and fourth transistors comprise PMOS transistors.

3. The apparatus of claim 2, wherein the fourth transistor is to operate at a lower threshold voltage than the second transistor.

4. The apparatus of claim 3, wherein the second transistor is to operate at a threshold voltage of not more than 250 mV and the fourth transistor is to operate at a threshold voltage of not more than 200 mV.

5. The apparatus of claim 2, wherein the first transistor cell comprises a plurality of first NMOS transistors comprising first NMOS gate electrodes and a plurality of first PMOS transistors comprising first PMOS gate electrodes separated from the first NMOS gate electrodes by the dielectric material, and the second transistor cell comprises a plurality of second NMOS transistors and a plurality of second PMOS transistors, wherein corresponding ones of the second NMOS and PMOS transistors comprise shared gate electrodes extending orthogonal to the third semiconductor body.

6. The apparatus of any of claims 1 to 5, wherein the first transistor comprises a first channel region, the second transistor comprises a second channel region, the third transistor comprises a third channel region, and the fourth transistor comprises a fourth channel region, and wherein the first and third channel regions comprise a first material composition and the second and fourth channel regions comprise a second material composition.

7. The apparatus of any of claims 1 to 6, wherein the contiguous third gate electrode comprises a first region over the third semiconductor body and a second region over the fourth semiconductor body, the first region comprising a first work function metal adjacent the third semiconductor body and the second region comprising a second work function metal adjacent the fourth semiconductor body.

8. The apparatus of claim 7, wherein the first and second region each comprises a common continuous fill metal over the first and second work function metals.

9. The apparatus of claim 8, wherein the first work function metal comprises ruthenium, palladium, platinum, cobalt, or nickel and the second work function metal comprises hafnium, zirconium, titanium, tantalum, or aluminum.

10. The apparatus of any of claims 1 to 9, wherein the second transistor cell further comprises a fifth transistor and a sixth transistor, wherein the fifth transistor shares a source or drain with the third transistor and the sixth transistor shares a source or drain with the fourth transistor, and wherein the fifth and sixth transistors comprise a contiguous fourth gate electrode.

11. The apparatus of claim 10, wherein the second transistor cell further comprises a seventh transistor comprising a fifth gate electrode coupled to the third semiconductor body, and an eighth transistor comprising a sixth gate electrode coupled to the fourth semiconductor body, wherein the dielectric material separates the fifth gate electrode from the sixth gate electrode.

12. The apparatus of claim 10, wherein the second transistor cell further comprises a seventh transistor and an eighth transistor, wherein the seventh transistor shares a source or drain with the fifth transistor and the eighth transistor shares a source or drain with the sixth transistor, and wherein the seventh and eighth transistors comprise a contiguous fifth gate electrode.

13. The apparatus of any of claims 1 to 12, wherein an integrated circuit (IC) die comprises the first transistor cell and the second transistor cell.

14. The apparatus of any of claims 1 to 13, wherein an integrated circuit (IC) die comprises the first transistor cell and the second transistor cell.

15. The apparatus of claim 14, further comprising a power supply coupled to the IC die.
